# EUROPÄISCHE PATENTSCHRIFT

(11) **EP 0 763 852 B1**
(45) Veröffentlichungstag und Bekanntmachung des Hinweises auf die Patenterteilung: **26.06.2002**
(21) Anmeldenummer: 96114182.7
(22) Anmeldetag: 04.09.1996
(51) Int. Cl.: H01L 23/053, H01L 23/16

(54) **Gehäuse für ein Leistungs-Halbleitermodul**
Housing for a power semiconductor module
Boîtier pour des modules à semi-conducteur de haute puissance

(30) Priorität: 18.09.1995 DE 19534607
(43) Veröffentlichungstag der Anmeldung: 19.03.1997
(73) Patentinhaber: eupec Europäische Gesellschaft für Leistungshalbleiter mbH & Co. KG, 59581 Warstein (DE)
(72) Erfinder: Hierholzer, Martin, Dr.-Ing., 59581 Warstein (DE); Spanke, Reinhold, Dipl.-Ing., 59909 Bestwig (DE)
(74) Vertreter: Patentanwälte Westphal, Mussgnug & Partner

(56) Entgegenhaltungen:
- GB-A- 2 057 762
- US-A- 4 323 874
- US-A- 4 774 155

## Beschreibung

Die Erfindung bezieht sich auf ein Gehäuse für ein Leistungs-Halbleitermodul, mit einem Metallboden und einem aus Isolierstoff bestehenden, auf dem Metallboden sitzenden Gehäuseoberteil, das Seitenwände und einen Deckel hat.

Leistungs-Halbleitermodule mit solchen Gehäusen sind seit langem Stand der Technik. Sie werden z.B. als Brücken in Wechselrichtern eingesetzt. Dabei ist der Brücke ein Stützkondensator hoher Kapazität parallel geschaltet. Kann eines der Leistungs-Halbleiterbauelemente der Brücke wegen eines Defektes nicht mehr gesperrt werden, so kann sich die Energie des Stützkondensators durch den defekten Brückenzweig schlagartig entladen. Die umgesetzte Energie ist dabei so hoch, daß das Leistungs-Halbleitermodul explodiert. Dabei werden seine Einzelteile im Stromrichter umhergeschleudert und umfangreiche Austausch- und Reinigungsarbeiten werden erforderlich.

Aus der US-A-4 774 155 ist ein dicht verschlossenes galvanisches Element mit einer Sollbruchstelle in einem aus Stahl bestehenden Wandmaterial beschrieben. In der GB-A-2 057 762 ist eine explosionssichere Halbleitervorrichtung beschrieben, die ein Gehäuse aufweist, dessen Innenraum eine luftdicht gekapselte Kammer bildet und welches das Halbleiterbauelement umschließt, wobei ein Explosionsschutzelement, welches die bei einer Explosion des Halbleiterbauelements auftretenden Kräfte zu absorbieren bzw. aufzufangen vermag, unter Umschließung des Halbleiterbauelements in das Gehäuse eingesetzt ist.

Es ist Ziel der Erfindung, ein Gehäuse der angegebenen Art so weiter zu entwickeln, daß eine Explosion vermieden werden kann.

Dieses Ziel wird dadurch erreicht, daß wenigstens eine der Seitenwände mindestens einen definierten Bereich hat, der sich bei einem vorgegebenen, im Inneren des Gehäuses aufbauenden Druck nach außen öffnet.

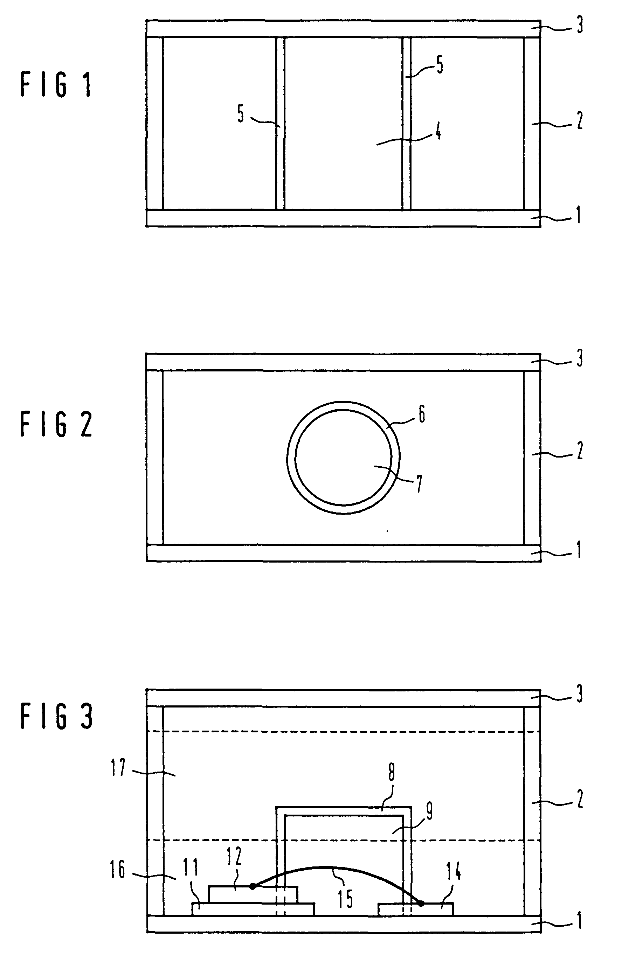

Die Erfindung wird anhand dreier Ausführungsbeispiele in Verbindung mit den Figuren 1 bis 3 näher erläutert. Diese Figuren zeigen schematische Schnitte durch jeweils ein Ausführungsbeispiel eines Gehäuses.

Das Gehäuse nach Figur 1 hat einen Metallboden, auf dem ein aus Isolierstoff bestehendes Gehäuseoberteil sitzt. Das Gehäuseoberteil hat Seitenwände 2 und einen Deckel 3. Es kann, wie dargestellt, zweiteilig ausgeführt sein. Seitenwände und Deckel können aber auch ein einziges Teil bilden. Wenigstens eine der Seitenwände 2 ist mit einem Bereich 4 versehen, der durch zwei parallele Nuten begrenzt ist. Diese Nuten reichen über die gesamte Höhe der Seitenwand.

Beim Aufbau eines Drucks im Inneren des Leistungs-Halbleitermoduls wird der durch die Nuten definierte Bereich 4 nach außen gedrückt, so daß sich der Druck abbauen kann. Eine Explosion des Gehäuses wird damit vermieden.

Die Ausführungsform nach Figur 2 unterscheidet sich von der nach Figur 1 dadurch, daß eine der Seitenwände mit einem definierten kreisrunden Bereich 7 versehen ist. Dieser wird durch eine einzige kreisrunde Nut 6 begrenzt. Der Bereich 7 kann aber auch rechteckig oder beliebig geformt sein.

Die Nuten 5, 6 werden vorzugsweise auf der Innenseite des Gehäuses angebracht. Um eine Öffnung des Gehäuses zu ermöglichen bevor es explosiert, empfiehlt es sich, die Nut relativ tief zu machen. Eine Tiefe von mehr als die Hälfte der Dicke der Seitenwand hat sich bewährt.

Ein Leistungs-Halbleitermodul enthält Halbleiterbauelemente, interne Leiter und Leiterbahnen. Als Korrosionsschutz enthalten diese Gehäuse meistens eine erste Schicht aus einer weichen Vergußmasse, die die Halbleiterbauelemente umhüllt. Auf der ersten Schicht ist eine zweite Schicht aus einer harten Vergußmasse aufgebracht. Dies ist im Ausführungsbeispiel nach Figur 3 schematisch angedeutet. Hier ist ein Halbleiterbauelement mit 12 bezeichnet. Es ist auf einer Leiterbahn 11 montiert und mit dieser kontaktiert. Seine Oberseite ist durch einen Bonddraht 15 mit einer weiteren Leiterbahn 14 elektrisch verbunden. Das Modul ist mit einer ersten Schicht 16 der erwähnten weichen Vergußmasse gefüllt. Darüber liegt eine Schicht 17 der erwähnten harten Vergußmasse. Für einen kontrollierten Druckabbau empfiehlt es sich, den sich im Falle eines Druckaufbaus öffnenden Bereich so auszubilden, daß er an die weiche Vergußmasse 16 angrenzt. Der Bereich ist hier mit 9 bezeichnet, er erstreckt sich vom Boden es Gehäuses über die Höhe der weichen Vergußmasse hinaus. Er ist durch eine Nut 8 begrenzt. Bei einem Druckaufbau wird dann die weiche Vergußmasse aus dem Gehäuse geschleudert, so daß eine Beschädigung anderer Teile des Stromrichters vermieden wird.

## Patentansprüche

1. Gehäuse für ein Leistungs-Halbleitermodul, mit einem Metallboden und einem aus Isolierstoff bestehenden, auf dem Metallboden sitzenden Gehäuseoberteil, das Seitenwände und einen Deckel hat, bei dem wenigstens eine der Seitenwände (2) mindestens einen definierten Bereich (4, 7, 9) hat, der sich bei einem vorgegebenen, im Inneren des Gehäuses (1, 2, 3) aufbauenden Druck nach außen öffnet.

2. Gehäuse nach Anspruch 1,
**dadurch gekennzeichnet, daß** der Bereich (7) von mindestens einer in der Seitenwand vorgesehenen Nut (6) begrenzt ist.

3. Gehäuse nach Anspruch 2,
**dadurch gekennzeichnet, daß** der Bereich (4) von zwei parallelen Nuten (5) begrenzt ist.

4. Gehäuse nach Anspruch 2 oder 3,
**dadurch gekennzeichnet, daß** die Nut auf der Innenseite der Seitenwand angebracht ist.

5. Gehäuse nach einem der Ansprüche 2 bis 4,
**dadurch gekennzeichnet, daß** die Nut tiefer als die Hälfte der Dicke der Seitenwand ist.

6. Gehäuse mit Leistungs-Halbleiterbauelementen, die mit einer ersten Schicht aus einer weichen Vergußmasse bedeckt sind und mit einer zweiten Schicht aus einer harten Vergußmasse, die auf der ersten Schicht liegt,
**dadurch gekennzeichnet, daß** der Bereich (9) an die erste Schicht (16) angrenzt.

## Claims

1. A housing for a power semiconductor module, with a metal base and an upper housing part made from an insulating material, seated on the metal base and having side walls and a cover, in which at least one of the side walls (2) has at least one defined region (4, 7, 9) which opens outwards in the event of a predetermined pressure building up in the interior of the housing (1, 2, 3).

2. A housing according to Claim 1,
**characterised in that** the region (7) is limited by at least one groove (6) provided in the side wall.

3. A housing according to Clam 2,
**characterised in that** the region (4) is limited by two parallel grooves (5).

4. A housing according to Claim 2 or 3,
**characterised in that** the groove is mounted on the inside of the side wall.

5. A housing according to one of Claims 2 to 4,
**characterised in that** the groove is deeper than half the thickness of the side wall.

6. A housing with power semiconductor components, which are covered with a first layer of a soft sealing material and with a second layer of a hard sealing material lying on the first layer,
**characterised in that** the region (9) is adjacent to the first layer (16).

## Revendications

1. Boîtier pour un module à semi-conducteur de haute puissance, avec un fond métallique et une partie supérieure de boîtier en un matériau isolant, disposée sur le fond métallique, comportant des parois latérales et un couvercle
dans lequel
au moins l'une des parois (2) comporte au moins une zone définie (4, 7, 9) s'ouvrant vers l'extérieur, sous la poussée d'une pression déterminée prenant naissance à l'intérieur du boîtier(1, 2, 3).

2. Boîtier selon la revendication 1,
**caractérisé en ce que**
la zone (7) est limitée par au moins une rainure (6) prévue dans la paroi latérale.

3. Boîtier selon la revendication 2,
**caractérisé en ce que**
la zone (4) est limitée par deux rainures (5) parallèles.

4. Boîtier selon la revendication 2 ou 3,
**caractérisé en ce que**
la rainure est disposée sur la face intérieure de la paroi latérale.

5. Boîtier selon la revendication 2 à 4,
**caractérisé en ce que**
la rainure a une profondeur supérieure à la moitié de l'épaisseur de la paroi latérale.

6. Boîtier avec éléments de semi-conducteur de haute puissance, recouverts d'une première couche d'une masse coulée molle et d'une seconde couche d'une masse coulée dure appliquée sur la première couche,
**caractérisé en ce que**
la zone (9) est adjacente à la première couche (16).
